# EUROPÄISCHE PATENTSCHRIFT

(11) **EP 1 279 191 B1**
(45) Veröffentlichungstag und Bekanntmachung des Hinweises auf die Patenterteilung: **05.07.2006**
(21) Anmeldenummer: 01943320.0
(22) Anmeldetag: 04.05.2001
(51) Int. Cl.: H01L 21/331

(54) **Verfahren zur Herstellung eines Bipolartransistors**
Method for producing a bipolar transistor
Procédé de production d'un transistor bipolaire

(30) Priorität: 05.05.2000 EP 00109644
(43) Veröffentlichungstag der Anmeldung: 29.01.2003
(73) Patentinhaber: Infineon Technologies AG, 81669 München (DE)
(72) Erfinder: MÜLLER, Karl-Heinz, 84149 Velden (DE); WOLF, Konrad, 83624 Otterfing (DE)
(74) Vertreter: Ginzel, Christian
(86) Internationale Anmeldenummer: PCT/EP2001/005036
(87) Internationale Veröffentlichungsnummer: WO 2001/086711

(56) Entgegenhaltungen:
- EP-A- 0 418 185
- EP-A- 0 600 276
- EP-A- 0 724 298
- US-A- 5 773 350
- GREGORY H J ET AL: "FULLY-SELF-ALIGNED SI BIPOLAR TRANSISTOR WITH COLLECTOR AND BASE GROWN USING SILANE-ONLY SELECTIVE EPITAXY" ELECTRONICS LETTERS,GB,IEE STEVENAGE, Bd. 32, Nr. 9, 25. April 1996 (1996-04-25), Seiten 850-851, XP000595688 ISSN: 0013-5194
- PATENT ABSTRACTS OF JAPAN vol. 1995, no. 06, 31. Juli 1995 (1995-07-31) & JP 07 086301 A (OKI ELECTRIC IND CO LTD), 31. März 1995 (1995-03-31)

## Beschreibung

Die Erfindung betrifft ein Verfahren zur Herstellung von Bipolartransistoren, wie sie beispielsweise in der Hochfrequenztechnik eingesetzt werden können.

Bipolartransistoren sind die Transistoren der Wahl, wenn es um hohe Schaltgeschwindigkeiten und/oder hohe Ausgangsleistungen geht. Moderne Bipolartransistoren können bei Frequenzen von 50 GHz und mehr betrieben werden. Für eine weitere Steigerung der Schaltgeschwindigkeit müssen jedoch noch eine Reihe von Schwierigkeiten beseitigt werden. Als frequenzlimitierende Parameter gelten insbesondere die parasitäre Kapazität zwischen Kollektor und Basis sowie der Basiswiderstand. Beide Parameter konnten durch Miniaturisierung, die durch Methoden wie die Selbst-Justierung von Basis und Emitter, LOCOS-Prozeßschrittfolgen, Grabentechniken und ausgefeilte Schichttechniken, wie selektive Epitaxie, ermöglicht wurde, immer weiter reduziert werden.

Eine weitere Verbesserung bieten Bipolartransistoren mit Hetero-Übergängen. Bipolartransistoren mit Hetero-Übergängen sind Bipolartransistoren, bei denen Emitter und Basis unterschiedliche Materialien bzw. unterschiedliche Kristallstrukturen mit unterschiedlichen Energieabständen der verbotenen Zonen aufweisen. Durch eine geeignete Wahl der Materialien von Basis und Emitter können die Energiebänder so aufeinander abgestimmt werden, daß die Emitter-Effizienz und die Stromverstärkung des Transistors sehr hoch sind und die Basis hoch dotiert und damit gut leitend ausgelegt werden kann. Ein typischer Vertreter dieser Art von Bipolartransistoren ist der Si/SiGe-Bipolartransistor.

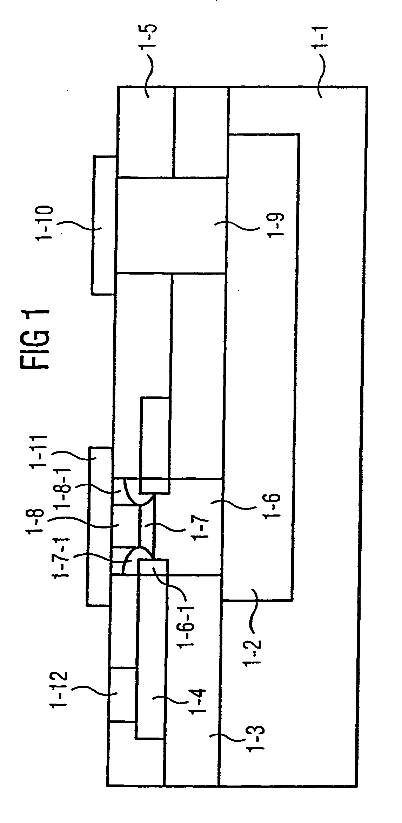

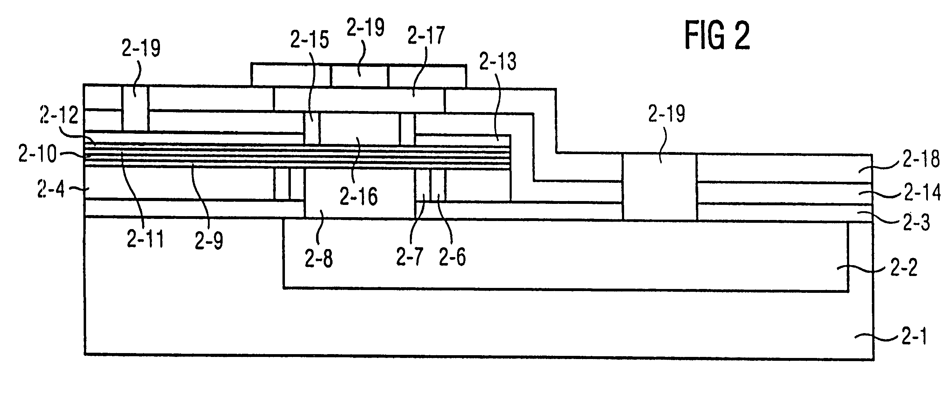

Zwei Ausführungsformen derartiger Bipolartransistoren sind in der US-Patentschrift 5,962,879 offenbart, die im folgenden im Zusammenhang mit den Figuren 1 und 2 erläutert werden.

Fig. 1 zeigt einen Querschnitt durch einen npn Si/SiGe Bipolartransistor mit selbst-justiertem Kollektor-Basis-Übergang. In ein p-dotiertes Siliziumsubstrat 1-1 wurde durch Implantation eine vergrabene n⁺-Schicht 1-2 erzeugt. Die isolierende Schicht 1-3, die Polysiliziumschicht 1-4 und eine weitere isolierende Schicht 1-5 sind über der vergrabenen n⁺-Schicht geöffnet, um dort Kollektor 1-6, Basis 1-7 und Emitter 1-8 durch selektive Epitaxie, bevorzugt in einem Prozeßschritt, aufzuwachsen.

Während des Aufwachsens der Schichten 1-6, 1-7 und 1-8 in dem geöffneten Bereich bilden sich jedoch an der Seitenwand der Polysiliziumschicht 1-4 ungewollt dünne polykristalline oder amorphe Siliziumschichten 1-6-1, 1-7-1 und 1-8-1, die wie in Fig. 1 gezeigt auch in die Bereich von Emitter und Kollektor hineinreichen können. Diese ungewollten Schichten können einen Kurzschluß zwischen Emitter und Kollektor verursachen, was den Transistor unbrauchbar macht.

Fig. 2 zeigt einen weiteren Bipolartransistor nach Stand der Technik, bei dem der oben beschriebene Nachteil der Kurzschlußbildung umgangen wird. Dies wird dadurch erreicht, daß die Polysiliziumschicht, welche den Anschluß der Basis gewährleistet, durch eine Seitenwandisolation räumlich von dem Basis/Kollektor-Bereich abgetrennt und die Basis nicht durch eine selektive sondern durch eine ganzflächige Abscheidung erzeugt wird. Dementsprechend entstehen keine polykristallinen oder amorphen Siliziumschichten im Bereich der Basis, so daß ein Kurzschluß zwischen Emitter und Kollektor verhindert wird.

Zur Herstellung des in Fig. 2 gezeigten Bipolartransistors wird ein p-Siliziumsubstrat 2-1 mit einer vergrabenen n⁺⁻Schicht 2-2 bereitgestellt. Eine Oxidschicht 2-3, eine p⁺⁻Polysiliziumschicht 2-4 und ein weiteres Zwischenoxid (nicht gezeigt) werden auf das Substrat aufgebracht und mittels eines photolithographischen Verfahrens im Bereich des aktiven Transistorbereiches bis zur Oxidschicht 2-3 geöffnet. Anschließend wird die Wand des geöffneten Bereichs durch einen ersten Oxidspacer 2-6 und einem zweiten Nitridspacer 2-7 abgedeckt. Dann wird auch das Oxid 2-3 geöffnet und das Zwischenoxid auf der Polysiliziumschicht 2-4 soweit geätzt, daß es dieselbe Dicke wie das Oxid 2-3 hat. Es folgt ein erster selektiver Epitaxieschritt, mit dem eine monokristalline Siliziumschicht, die den Kollektor 2-8 darstellt, auf das geöffnete Silizium aufgewachsen wird.

Nach der Erzeugung des Kollektors 2-8 wird das Zwischenoxid auf der Polysiliziumschicht 2-4 weggeätzt. Auch der NitridSpacer 2-7 wird an der Oberkante soweit abgeätzt, bis er die Höhe der Oberkante der Polysiliziumschicht 2-4 erreicht. Danach wird die Basis monokristallin auf den Kollektor aufgewachsen, wobei die Basis in dieser Ausführung aus den monokristallinen Schichten Silizium 2-9, nichtdotiertem SiGe 2-10, p-dotiertem SiGe 2-11 und wieder Silizium 2-12 besteht. Die Schichten 2-10,2-11 und 2-12 können aber auch aus p-dotiertem Silizium bestehen, die während des Aufwachsprozesses dotiert werden. Das Aufwachsen der Basis geschieht ganzflächig und nicht selektiv, d.h. die Schichten überdecken den Kollektor und die Polysiliziumschicht 2-4, über welche die Basis nach außen kontaktiert wird.

Im weiteren wird auf die Siliziumschicht 2-12 eine Metall oder Silicide-Schicht 2-13 aufgebracht, um den Leitungswiderstand zu der Basis zu reduzieren, und zusammen mit den Basisschichten 2-9, 2-10, 2-11 und 2-12 strukturiert. Dann folgt eine weitere Oxidschicht 2-14 und die Erzeugung einer Öffnung mit den Spacern 2-15. In der Öffnung wird der Emitter 2-16 erzeugt, d.h. Silizium, das in-situ dotiert wird, wird selektiv und monokristallin auf die Basis aufgewachsen. Um den Prozeß abzuschließen werden noch die Polysiliziumschicht 2-17, die den Emitter kontaktiert, eine Passivierungschicht 2-18 aufgebracht und die intermetallischen Verbindungen 2-19 zu Basis und Kollektor und Emitter erzeugt.

Nachteilig an diesem Verfahren ist jedoch, daß Kollektor, Basis und Emitter in separaten Epitaxieschritten aufgebracht werden müssen, was prozeßtechnisch sehr aufwendig und daher sehr teuer ist. Weiterhin ist auch die Erzeugung der verschiedenen Spacer 2-6, 2-7 und 2-15 sehr aufwendig.

Ein Verfahren zur Herstellung eines Bipolartransistors ist in US 5 773 350 offenbart. Ein weiteres Verfahren zur Herstellung eines Bipolartransistors ist in H.J. Gregory et a.: Electronics Letters 1996, vol. 32, no. 9, pages 850-851 offenbart. Bei diesem Verfahren werden eine erste Oxidschicht, eine p-dotierte Polysiliziumschicht sowie eine zweite Oxidschicht auf einem Halbleitermaterial abgeschieden. Nachfolgend werden die zweite Oxidschicht anisotrop, dann die Polysiliziumschicht isotrop und schließlich die erste Oxidschicht wieder anisotrop geätzt. Dadurch entsteht eine Öffnung zum Halbleitermaterial, wobei die Polysiliziumschicht durch die isotrope Ätzung gegenüber den Ätzkanten der Oxidschichten zurückgeätzt ist. Abschließend werden Kollektor, Basis und Emitter in der Öffnung epitaktisch abgeschieden.

Der vorliegenden Erfindung liegt daher die Aufgabe zugrunde, ein Verfahren zur Herstellung eines Bipolartransistors anzugeben, das die oben gezeigten Schwierigkeiten nicht oder nur vermindert aufweist und mit dem die Anzahl der Prozeßschritte möglichst gering gehalten oder sogar zu reduziert werden können.

Diese Aufgabe wird von dem Verfahren zur Herstellung eines Bipolartransistors gemäß der unabhängigen Patentansprüche 1 und 2 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Herstellung eines Bipolartransistors bereitgestellt, das folgende Schritte aufweist:
a) ein Halbleitersubstrat mit einem leitenden Gebiet wird bereitgestellt,
b) zumindest eine erste isolierende Schicht, zumindest eine leitende Schicht und zumindest eine zweite isolierende Schicht werden nacheinander auf das Halbleitersubstrat aufgebracht,
c) eine Maske wird aufgebracht,
d) eine im wesentlichen anisotrope Ätzung der zweiten isolierenden Schicht und der leitenden Schicht wird durchgeführt,
e) eine thermische Oxidation der Seitenwand der leitenden Schicht wird durchgeführt, so daß an der Seitenwand der leitenden Schicht eine Oxidschicht erzeugt wird,
f) eine im wesentlichen anisotrope Ätzung der ersten isolierenden Schicht wird durchgeführt, so daß eine Öffnung zu dem leitenden Gebiet erzeugt wird,
g) ein Kollektor wird durch selektive Epitaxie in der Öffnung erzeugt,
h) die Oxidschicht an der Seitenwand der leitenden Schicht wird sodann abgeätzt,
i) eine Basis, welche mit der leitenden Schicht verbunden ist, wird durch selektive Epitaxie in der Öffnung erzeugt, und
j) ein Emitter wird erzeugt.

Weiterhin wird erfindungsgemäß ein Verfahren zur Herstellung eines Bipolartransistors bereitgestellt, das folgende Schritte aufweist:
a) ein Halbleitersubstrat mit einem leitenden Gebiet wird bereitgestellt,
b) zumindest eine erste isolierende Schicht, zumindest eine leitende Schicht und zumindest eine zweite isolierende Schicht werden nacheinander auf das Halbleitersubstrat aufgebracht,
c) eine Maske wird aufgebracht,
d) eine anisotrope Ätzung der zweiten isolierenden Schicht und der leitenden Schicht wird durchgeführt,
e) eine thermische Oxidation der Seitenwand der leitenden Schicht wird durchgeführt, so daß an der Seitenwand der leitenden Schicht eine Oxidschicht erzeugt wird,
f) eine anisotrope Ätzung der ersten isolierenden Schicht wird durchgeführt, so daß eine Öffnung zu dem leitenden Gebiet erzeugt wird,
g) die Oxidschicht an der Seitenwand der leitenden Schicht wird abgeätzt,
h) ein Kollektor und eine Basis, welche mit der leitenden Schicht verbunden ist, werden sodann durch selektive Epitaxie in der Öffnung erzeugt, und
i) ein Emitter wird erzeugt.

Die erfindungsgemäßen Verfahren können sowohl für die Herstellung von npn-Transistoren als auch von pnp-Transistoren verwendet werden. Die erfindungsgemäßen Verfahren besitzen den Vorteil, daß durch die anisotrope Ätzung der leitenden Schicht und die Oxidation der leitenden Schicht und anschießende Entfernung der Oxidschicht der Bereich der Basis verbreitert wird, so daß bei der nachfolgenden Erzeugung der Basis keine Kurzschlüsse zwischen Emitter und Kollektor auftreten können. In dieser Hinsicht besitzen die erfindungsgemäßen Verfahren den gleichen Vorteil wie das in Zusammenhang mit Fig. 2 beschriebene Verfahren. Jedoch wird bei den erfindungsgemäßen Verfahren dieser Vorteil mit Hilfe eines wesentlich einfacheren und damit kostengünstigeren Verfahrensablauf erzielt.

Bevorzugt ist das leitende Gebiet eine implantierte Schicht, die auch vergrabene Schicht genannt wird. Das leitende Gebiet dient dazu, eine möglichst niederohmige leitende Verbindung zwischen dem Kollektor und dem seitlich versetzten Kollektor-Kontaktloch herzustellen.

Die erste isolierende Schicht, die leitende Schicht und die zweite isolierende Schicht dienen als zu strukturierendes Maskenmaterial für die Platzierung des Transistors auf das Halbleitersubstrat. Die leitende Schicht hat zusätzlich die Funktion, die aufzubringende Basis des Bipolartransistors nach außen hin zu kontaktieren. Bevorzugt ist die zweite isolierende Schicht ein Siliziumoxid, die leitende Schicht ein dotiertes Polysilizium und die erste isolierende Schicht eine Schicht, die bevorzugt aus zwei Teilschichten besteht. Bevorzugt ist die erste Teilschicht, die auf dem Halbleitersubstrat aufgebracht ist, eine Oxidschicht, während die zweite Teilschicht, die auf der ersten Teilschicht aufgebracht ist, eine Nitridschicht ist.

Die zweite Teilschicht dient unter anderem als Ätzstop für die anisotrope Ätzung, mit der die zweite isolierende Schicht und die leitende Schicht geöffnet werden. Die erste Teilschicht ist bevorzugt ein isolierendes Material mit kleiner Dielektrizitätskonstante, um eine kleine parasitäre Kapazität zwischen Halbleitersubstrat (einschließlich vergrabener Schicht) und leitender Schicht zu haben. Bevorzugtes Material für die erste Teilschicht ist Siliziumoxid.

Mit Hilfe der Maske werden auf photolithographischem Wege die zweite isolierende Schicht, die leitende Schicht und die erste isolierende Schicht so geöffnet, daß eine Öffnung zu dem leitenden Gebiet erzeugt ist. Die Öffnung der ersten und der zweiten isolierenden Schicht geschieht dabei durch ein überwiegend anisotropes Ätzverfahren.

In einer bevorzugten Ausführung wird die Seitenwand der leitenden Schicht anschließend oxidiert oder mit einer Oxidschicht versehen. Diese Oxidation verhindert, daß sich das beim epitaktischen Wachsen des Kollektors angebotene Silizium samt seinem Dotierungsmaterial an der Wandfläche der Polysiliziumschicht ablagert. Später wird die Oxidation mit den aufgewachsenen Materialien wieder entfernt.

Durch selektive Epitaxie werden erst der Kollektor und dann die Basis in der Öffnung erzeugt. Die Kollektorschicht ist dabei so dick zu wählen, daß sie nicht in den Bereich der leitenden Schicht reicht. Die Schichtdicke der Basis ist so zu wählen, daß ihre Seitenwand die Seitenwand der leitenden Schicht überdeckt.

Ist die Seitenwand der isolierenden Schicht oxidiert oder mit einer isolierenden Schicht bedeckt worden, so ist diese Oxidschicht nach der Kollektorerzeugung und vor der Basiserzeugung abzuätzen. In diesem Falle werden Kollektor und Basis nicht in einem Prozeßschritt erzeugt. Das Dotierungsprofil von Kollektor und Basis werden dann zwar auch bevorzugt in-situ eingestellt, aber das in zwei getrennten Prozeßschritten. Der Vorteil dieses Verfahrens liegt darin, daß sich während des Epitaxieschrittes zur Erzeugung des Kollektors kein Silizium auf der Oxidoberfläche der Seitenwand der leitenden Schicht ablagert, so daß nach Beseitigung der Oxidschicht die im folgenden Schritt aufzubringende Basis auf das ursprüngliche Material der leitenden Schicht trifft. Dementsprechend führt dies zu einem besonders niederohmigen Widerstand zwischen leitender Schicht und aktivem Basisbereich.

Die Erzeugung des Emitters geschieht mit Verfahren nach dem Stand der Technik. Bevorzugt wird der Emitter durch eine n⁺⁻Polysiliziumschicht, die anschließend strukturiert wird, erzeugt.

In den erfindungsgemäßen Verfahren nach Anspruch 1 bzw. 2 werden die erste isolierende Schicht, leitende Schicht und die zweite isolierende Schicht durch anisotrope Ätzung über dem leitenden Gebiet geöffnet. Die leitende Schicht wird nicht durch einen zusätzlichen isotropen Ätzschritt behandelt. Statt dessen wird die Seitenwand der leitenden Schicht oxidiert, wobei die Oxidschicht bis zu einer vorgegebenen Ausdehnung in die leitende Schicht zwischen den beiden isolierenden Schichten eindringt.

Die Oxidation der leitenden Schicht bringt eine Reihe von Vorteilen mit sich. Die Oxidschicht erzeugt eine erweiterte Öffnung der leitenden Schicht dadurch, daß das Oxid in die leitenden Schicht erst hineinwächst und danach beseitigt wird.

So dient die erweiterte Öffnung der leitenden Schicht beim Erzeugen der Basis mittels selektiver Epitaxie dazu, das bei diesem Prozeß sich ablagernde Silizium und seine Dotierung aufzunehmen und es nicht zum dem aktiven Bereich der Basis reichen zu lassen. Weiterhin läßt sich durch eine Oxidation und anschließende Entfernung der Oxidschicht die Öffnung in der leitenden Schicht häufig genauer und reproduzierbarer einstellen als dies durch eine einfache Ätzung der leitenden Schicht möglich ist.

Wird die Oxidschicht erst nach der Erzeugung des Kollektors wieder entfernt, so schützt die Oxidschicht die leitende Schicht vor der Ablagerung während der Erzeugung des Kollektors. Wird die Oxidschicht vor der Erzeugung des Kollektors wieder entfernt, so können Kollektor und Basis durch eine gemeinsame selektive Epitaxie erzeugt werden. Dabei kann die Oxidschicht kann bereits entfernt werden bevor die erste isolierende Schicht geöffnet wird.

Bevorzugt wird das Verfahren angewandt auf ein Halbleitersubstrat, das keine Epitaxieschicht aufweist. Dies erspart Kosten und Zeit, da das Aufbringen von Epitaxieschichten aufwendig ist. Da im erfindungsgemäßen Verfahren der Kollektor epitaktisch in isolierenden Schichten eingebettet ist, sind vergrabene Schicht und Basis durch mindestens die Dicke der ersten isolierenden Schicht voneinander räumlich getrennt.

Die Einbettung des Kollektors in die isolierende Schicht reduziert ferner die Randkapazitäten zwischen Basis und Kollektor. Durch die geeignete Wahl des Materials mit niedriger Dielektrizitätskonstante können die Randkapazität weiter reduziert werden. Bevorzugt umfaßt die erste isolierende Schicht ein Siliziumoxid und eine darauf aufliegende Siliziumnitridschicht.

Bevorzugt wird nach Aufbringung der Basis ein Temperaturschritt durchgeführt, mit dem das Dotierungsmaterial der leitenden Schicht, die bevorzugt hochdotiertes Polysilizium ist, in den seitlichen Bereich der Basis diffundieren. Der seitliche Bereich der Basis ist der Bereich der Basis, der nicht aktiv ist, d.h. keinen Schichtübergang gleichzeitig mit Kollektor und Emitter aufweist. Er hat daher die Funktion einer elektrischen Verbindung zwischen der aktiven Basis und dem Polysilizium.

Die seitliche Eindiffundierung von Dotierungsmaterial vom Polysilizium in den seitlichen Bereich der Basis hilft dabei, den elektrischen Widerstand zwischen leitender Schicht und aktiver Basis zu reduzieren und den Bipolartransistor damit schneller zu machen. Das Diffusionsprofil kann dabei durch Dauer und Temperatur des Temperaturschrittes eingestellt werden. Bevorzugt werden Dauer und Temperatur des Temperaturschrittes so eingestellt, daß die Diffusion bis zum aktiven Bereich der Basis reicht; so wird der kleinste Widerstand zwischen leitender Schicht und aktiven Basisbereich erzeugt. Es ist durch höhere Temperatur und/oder langere Dauer des Temperaturschrittes auch möglich das Dotierungsprofil der aktiven Basiszone auf diesem Wegen einzustellen.

Die Erzeugung der Emitters erfolgt nach Methoden nach Stand der Technik. Bevorzugt wird die Erzeugung des Emitters durch die Abscheidung einer Polysiliziumschicht auf die Basis bzw. durch eine weitere Epitaxie erreicht.

In bevorzugten erfindungsgemäßen Ausführungen weist die Basis Materialien auf, die von Silizium verschieden sind. Bevorzugte Materialien für Bipolartransistoren sind solche, bei denen die Basis eine schmalere "Verbotene Zone" hat als das Emittermaterial. Mit solchen Bipolartransistoren kann u.a. die Stromverstärkung erhöht, der Basiswiderstand erniedrigt und der Betriebstemperaturbereich erhöht werden. Bevorzugt ist eine Ausführung, in der Emitter Silizium und die Basis SiGe ist. Die Basis kann bevorzugt auch aus mehreren Schichten verschiedener Materialien bestehen, z.B. aus einer SiSiGe(1)-SiGe(2)-Si Folge, wobei SiGe(x) Schichten mit verschiedener Dotierung bezeichnen.

Die Erfindung und zwei Ausführungen nach Stand der Technik sind in den Figuren 1 bis 4 dargestellt:
- Fig. 1: eine erste Ausführungsform eines Bipolartransistors nach dem Stand der Technik,
- Fig. 2: eine zweite Ausführungsform eines Bipolartransistors nach dem Stand der Technik,
- Fig. 3a-3e: ein nicht erfindungsgemäßes Verfahren zur Herstellung eines Bipolartransistors
- Fig. 4a-4b: ein erstes erfindungsgemäßes Verfahren zur Herstellung eines Bipolartransistors.
- Fig. 5a-5b: ein zweites erfindungsgemäßes Verfahren zur Herstellung eines Bipolartransistors.

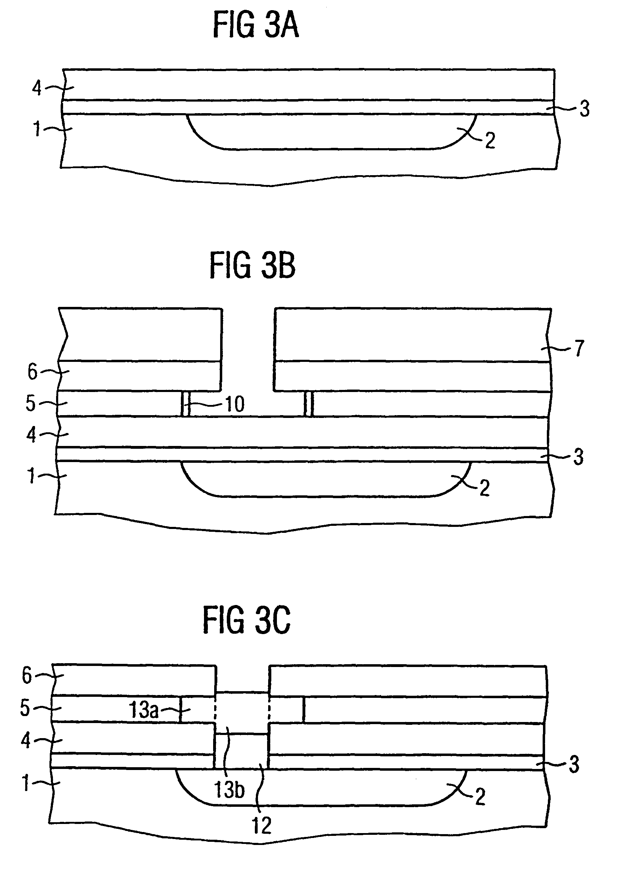

Fig. 3a bis Fig. 3e zeigen eine Ausführung eines Verfahrens zur Herstellung eines npn-Bipolartransistors, auf welches sich das erfindungsgemäße Verfahren teilweise bezieht.

Fig. 3a zeigt ein Halbleitersubstrat 1 aus p-dotiertem Silizium mit einer vergrabenen Schicht 2, die mit n-dotiertem Material implantiert ist, sowie mit einer thermischen Oxidschicht 3 und einer darauf liegenden Nitridschicht 4. Thermische Oxidschicht 3 und Nitridschicht 4 stellen zusammen eine erste isolierende Schicht dar. Die Dicke der Oxidschicht 3 und der Nitridschicht 4 zusammen ist so gewählt, daß sie gleich oder größer ist als die Dicke der noch zu erzeugenden Kollektorschicht.

Im folgenden wird eine Polysiliziumschicht 5 auf die Nitridschicht abgeschieden und mit p-dotierendem Material implantiert, so daß sich eine leitende Schicht bildet. Auf die Polysiliziumschicht 5 wird dann eine Oxidschicht 6 abgeschieden, die der zweiten isolierenden Schicht entspricht. Die sich daraus ergebende Situation ist in Figur 3b gezeigt.

Es folgt die im wesentlichen anisotrope Ätzung der Oxidschicht 6 und der Polysiliziumschicht 5 durch die Maske 7. Die Maskenöffnung befindet sich dabei über der vergrabenen Schicht 2. Danach folgt die isotrope Ätzung der leitenden Schicht 5, die das Polysilizium 5 zwischen den beiden isolierenden Schichten bis zu einer vorgegebenen Ausdehnung hinein wegätzt. Die Ausdehnung ist bevorzugt etwa so groß wie die Dicke der noch aufzubringenden Kollektorschicht gewählt. Die Ausdehnung definiert den seitlichen Basisbereich 13a, in dem bevorzugt der Übergang vom implantierten Polysilizium zum monokristallinen aktiven Basisbereich 13b stattfindet. Für einen niedrigen Basiswiderstand ist es wichtig, daß auch der seitliche Basisbereich möglichst niederohmig ausgelegt wird.

Optional kann die abgeätzte Seitenwand der Polysiliziumschicht 5 anschließend oxidiert oder auch mit einer Oxidschicht belegt werden, so daß auf der Polysiliziumwand eine Oxidschicht aufgebracht ist.

Im folgenden wird die Nitridschicht 4 im wesentlichen isotrop geätzt und die darunterliegende thermische Oxidschicht 3 danach naßchemisch geöffnet. Anschließend wird in einem Prozeßchritt Kollektor 12 und Basis 13 durch selektive Epitaxie auf die vergrabene Schicht 2 aufgewachsen. Das Dotierungsprofil wird in-situ während der Prozessierung eingestellt, wobei dieser Prozeßschritt eine große Variation von Dotierungsprofilen zuläßt. Bevorzugt ist der Kollektor eine n-dotiertes Silizium, während die Basis p-dotiertes SiGe ist. Es ist bei der Aufbringung der Kollektor- und Emitterschichten darauf zu achten, daß die Schicht der Basis die Seitenwand der Polysiliziumschicht 5 vollständig überdeckt.

Falls die Polysiliziumwand mit einer Oxidschicht versehen ist, können Kollektor und Basis nicht in einem Prozeßschritt erzeugt werden. In diesem Fall wird erst der Kollektor 12 durch ein selektives Epitaxieverfahren aufgewachsen, dann die Oxidschicht geätzt und dann erst die Basis 13 aufgewachsen. Die Oxidschicht bewirkt, daß sich während der Erzeugung des Kollektors 12 das Silizium nicht auf dem Polysilizium ablagern kann. Nach Aufbringung von Kollektor 12 und Basis 13 kann optional ein Spacer 15 auf die Basis aufgebracht werden. Die sich daraus ergebende Situation ist in Figur 3c gezeigt.

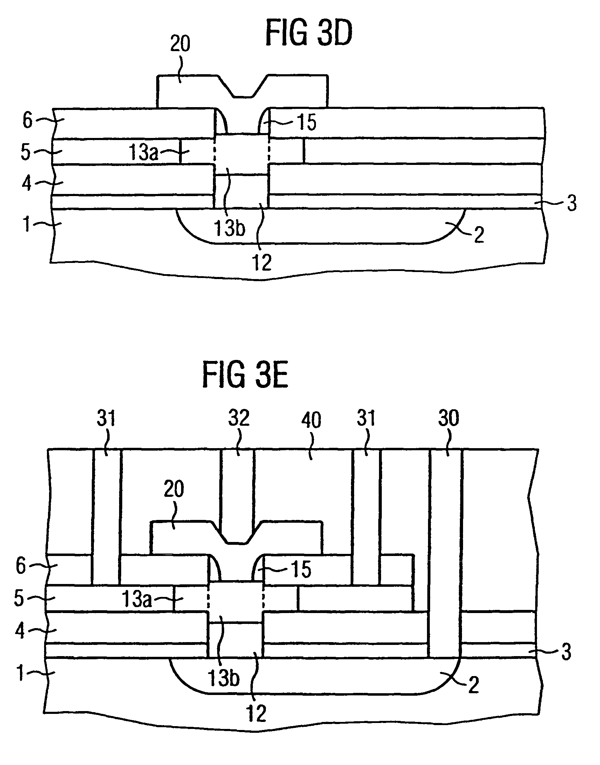

Anschließend wird das Polysilizium für den Emitter 20 aufgebracht und so strukturiert, daß es den aktiven Basisbereich 13b abdeckt. Anstatt einer Polysiliziumabscheidung kann zur Erzeugung des Emitters auch eine weitere selektive Epitaxie durchgeführt werden. Es folgen weitere Prozeßschritte nach Stand der Technik, die dazu dienen, ein Kontaktloch 30 auf die vergrabene Schicht 2 für eine Anschluß des Kollektors 12, ein Kontaktloch 31 auf die Polysiliziumschicht 5 für den Anschluß der Basis 13 und ein Kontaktloch 32 auf das Polysilizium 20 für den Anschluß des Emitters zu erzeugen. Die sich daraus ergebende Situation ist in Figur 3d gezeigt.

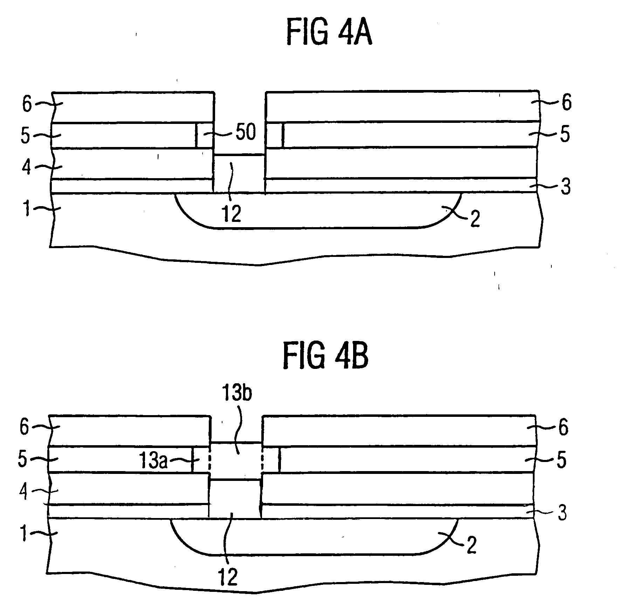

Fig. 4a und 4b zeigen zwei Schritte eines ersten erfindungsgemäßen Verfahrens, die von dem in den Figuren 3a bis 3e dargelegten Verfahren abweichen. Die ersten Schritte des ersten erfindungsgemäßen Verfahrens sind der Fig. 3a zu entnehmen. Anschließend werden eine thermische Oxidschicht oder eine Oxidabscheidung 3, eine Nitridschicht 4, eine Polysiliziumschicht 5 (samt p-Implantation) und eine Oxidschicht 6 wie in der vorhergehenden Ausführung auf das Substrat aufgebracht. Es folgt die Erzeugung der Maske 7, dann die anisotrope Ätzung von Oxidschicht 6 und Polysiliziumschicht 5 die so strukturiert wird wie in der vorhergehenden Ausführung. Abweichend von der vorhergehenden Ausführung findet dann eine Oxidation 50 an der Seitenwand der Polysiliziumschicht 5 statt, die sich zu einem Teil in das Polysilizium hineinfrißt. Die Oxidschicht 50 schützt das p-dotierte Polysilizium vor dem Material, das sich bei der folgenden selektiven Epitaxie zur Erzeugung des Kollektors 12 dort ablagern würde.

Danach wird der Kollektor 12 aus einem monokristallineme Silizium mit n-Dotierungsmaterial mittels selektiver Epitaxie erzeugt. Es folgt die Entfernung der Oxidschicht 50, so daß die p-dotierte Polysiliziumschicht 5 an der Seitenwand wieder freiliegt. Gleichzeitig ist dadurch ein Raum für den seitlichen Basisbereich 13a geschaffen worden, in dem der Übergang vom p-dotierten Polysilizium zum monokristallinen Silizium im Bereich der aktiven Basis 13b stattfinden kann.

Nun wird mittels selektiver Epitaxie die Basis erzeugt, die sich aus dem seitlichen Basisbereich 13a und dem aktiven Basisbereich 13b zusammensetzt (Fig. 4b). Die Dicke der Basisschicht ist bevorzugt dicker als die Dicke der Polysiliziumschicht und zwar so, daß sie die Polysiliziumschicht 5 vollständig abdeckt. Die folgenden Schritte zur Erzeugung des npn-Bipolartransistors sind dann wie in 3d und 3e.

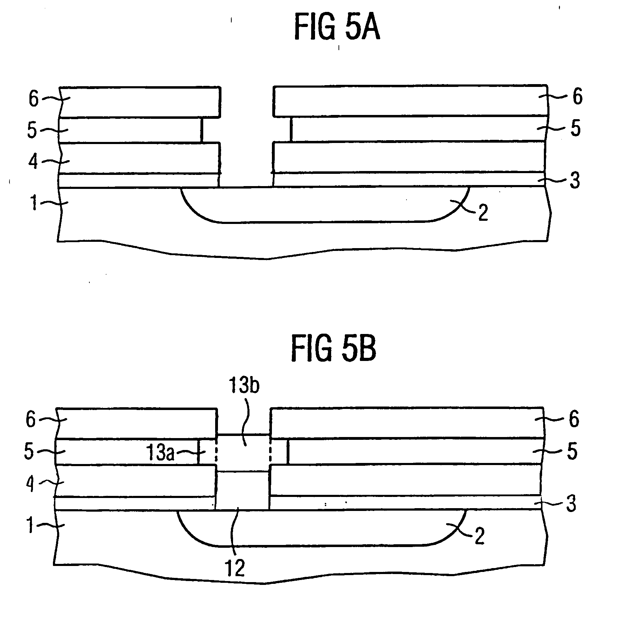

Fig. 5a und 5b zeigen zwei Schritte eines weiteren erfindungsgemäßen Verfahrens, die ebenfalls von dem in den Figuren 3a bis 3e dargelegten Verfahren abweichen. Die ersten Schritte dieses weiteren erfindungsgemäßen Verfahrens sind der Fig. 3a zu entnehmen. Anschließend werden eine thermische Oxidschicht oder eine Oxidabscheidung 3, eine Nitridschicht 4, eine Polysiliziumschicht 5 (samt p-Implantation) und eine Oxidschicht 6 wie in der vorhergehenden Ausführung auf das Substrat aufgebracht. Es folgt die Erzeugung der Maske 7, dann die anisotrope Ätzung von Oxidschicht 6 und Polysiliziumschicht 5 die so strukturiert wird wie in der vorhergehenden Ausführung. Wie bei der zweiten Ausführungsform der vorliegenden Erfindung findet dann eine Oxidation an der Seitenwand der Polysiliziumschicht 5 statt, die sich zu einem Teil in das Polysilizium hineinfrißt.

Im folgenden wird die Oxidschicht der Seitenwand der Polysiliziumschicht 5 nun vor der Erzeugung des Kollektors bzw. vor der Ätzung der Nitridschicht 4 selektiv zu dem Polysilzium der leitenden Schicht 5 entfernt. Anschließend werden die Nitridschicht 4 und die Oxidschicht 3 geöffnet, so daß sich die in Fig. 5a gezeigte Situation ergibt.

Da auf diese Weise die Oxidschicht an der Seitenwand der Polysiliziumschicht 5 bereits entfernt ist, können nun Kollektor 12 und Basis 13 entsprechend der ersten Ausführungsform der vorliegenden Erfindung in einem Schritt epitaktisch erzeugt werden. Die sich daraus ergebende Situation ist in Fig. 5b gezeigt. Die folgenden Schritte zur Erzeugung des npn-Bipolartransistors sind dann wiederum wie im Zusammenhang mit den Figuren 3d und 3e beschrieben.

## Patentansprüche

1. Verfahren zur Herstellung eines Bipolartransistors mit den folgenden Schritten:
a) ein Halbleitersubstrat mit einem leitenden Gebiet wird bereitgestellt,
b) zumindest eine erste isolierende Schicht, zumindest eine leitende Schicht und zumindest eine zweite isolierende Schicht werden nacheinander auf das Halbleitersubstrat aufgebracht,
c) eine Maske wird aufgebracht,
d) eine anisotrope Ätzung der zweiten isolierenden Schicht und der leitenden Schicht wird durchgeführt,
e) eine thermische Oxidation der Seitenwand der leitenden Schicht wird durchgeführt, so daß an der Seitenwand der leitenden Schicht eine Oxidschicht erzeugt wird,
f) eine anisotrope Ätzung der ersten isolierenden Schicht wird durchgeführt, so daß eine Öffnung zu dem leitenden Gebiet erzeugt wird,
g) ein Kollektor wird durch selektive Epitaxie in der Öffnung erzeugt,
h) die Oxidschicht an der Seitenwand der leitenden Schicht wird sodann abgeätzt,
i) eine Basis, welche mit der leitenden Schicht verbunden ist, wird durch selektive Epitaxie in der Öffnung erzeugt, und
j) ein Emitter wird erzeugt.

2. Verfahren zur Herstellung eines Bipolartransistors mit den folgenden Schritten:
a) ein Halbleitersubstrat mit einem leitenden Gebiet wird bereitgestellt,
b) zumindest eine erste isolierende Schicht, zumindest eine leitende Schicht und zumindest eine zweite isolierende Schicht werden nacheinander auf das Halbleitersubstrat aufgebracht,
c) eine Maske wird aufgebracht,
d) eine anisotrope Ätzung der zweiten isolierenden Schicht und der leitenden Schicht wird durchgeführt,
e) eine thermische Oxidation der Seitenwand der leitenden Schicht wird durchgeführt, so daß an der Seitenwand der leitenden Schicht eine Oxidschicht erzeugt wird,
f) eine anisotrope Ätzung der ersten isolierenden Schicht wird durchgeführt, so daß eine Öffnung zu dem leitenden Gebiet erzeugt wird,
g) die Oxidschicht an der Seitenwand der leitenden Schicht wird abgeätzt,
h) ein Kollektor und eine Basis, welche mit der leitenden Schicht verbunden ist, werden sodann durch selektive Epitaxie in der Öffnung erzeugt, und
i) ein Emitter wird erzeugt.

3. Verfahren nach einem der vorherigen Ansprüche,
**dadurch gekennzeichnet, daß**
die Dotierung von Kollektor und/oder Basis während der Epitaxieschritte eingestellt wird.

4. Verfahren nach einem der vorherigen Ansprüche,
**dadurch gekennzeichnet, daß**
die erste isolierende Schicht eine erste isolierende Unterschicht, die auf dem Halbleitersubstrat aufgebracht ist, und eine zweite isolierenden Unterschicht, die auf der ersten isolierenden Unterschicht aufgebracht ist, aufweist.

5. Verfahren nach einem der vorherigen Ansprüche,
**dadurch gekennzeichnet, daß**
die erste isolierende Unterschicht Siliziumoxid ist.

6. Verfahren nach einem der vorherigen Ansprüche,
**dadurch gekennzeichnet, daß**
die zweite isolierende Unterschicht Siliziumnitrid ist.

7. Verfahren nach einem der vorherigen Ansprüche,
**dadurch gekennzeichnet, daß**
die zweite isolierende Schicht Siliziumoxid ist.

8. Verfahren nach einem der vorherigen Ansprüche,
**dadurch gekennzeichnet, daß**
die leitende Schicht dotiertes Polysilizium ist.

9. Verfahren nach einem der vorherigen Ansprüche,
**dadurch gekennzeichnet, daß**
der elektrische Widerstand von der leitenden Schicht zum aktiven Bereich der Basis durch einen Temperaturschritt reduziert wird.

10. Verfahren nach einem der vorherigen Ansprüche,
**dadurch gekennzeichnet, daß**
der Emitter durch eine Polysiliziumabscheidung erzeugt wird.

11. Verfahren nach einem der vorherigen Ansprüche;
**dadurch gekennzeichnet, daß**
der Emitter durch eine epitaktische Abscheidung erzeugt wird.

12. Verfahren nach einem der vorherigen Ansprüche,
**dadurch gekennzeichnet, daß**
die Basis zumindest eine Schicht aus Silizium-Germanium aufweist.

13. Verfahren nach einem der vorherigen Ansprüche,
**dadurch gekennzeichnet, daß**
das Halbleitersubstrat keine Epitaxieschicht aufweist.

## Claims

1. Method for fabricating a bipolar transistor, comprising the following steps:
a) a semiconductor substrate with a conductive region is provided,
b) at least one first insulating layer, at least one conductive layer and at least one second insulating layer are successively applied to the semiconductor substrate,
c) a mask is applied,
d) an anisotropic etch of the second insulating layer and of the conductive layer is carried out,
e) thermal oxidation of the side wall of the conductive layer is carried out, so that an oxide layer is produced at the side wall of the conductive layer,
f) an anisotropic etch of the first insulating layer is carried out, so that an opening to the conductive region is produced,
g) a collector is produced by selective epitaxy in the opening,
h) the oxide layer on the side wall of the conductive layer is then etched away,
i) a base, which is connected to the conductive layer, is produced by selective epitaxy in the opening, and
j) an emitter is produced.

2. Method for fabricating a bipolar transistor, comprising the following steps:
a) a semiconductor substrate with a conductive region is provided,
b) at least one first insulating layer, at least one conductive layer and at least one second insulating layer are successively applied to the semiconductor substrate,
c) a mask is applied,
d) an anisotropic etch of the second insulating layer and of the conductive layer is carried out,
e) thermal oxidation of the side wall of the conductive layer is carried out, so that an oxide layer is produced at the side wall of the conductive layer,
f) an anisotropic etch of the first insulating layer is carried out, so that an opening to the conductive region is produced,
g) the oxide layer on the side wall of the conductive layer is etched away,
h) a collector and a base, which is connected to the conductive layer, are then produced by selective epitaxy in the opening, and
i) an emitter is produced.

3. Method according to one of the preceding claims, **characterized in that** the doping of collector and/or base is set during the epitaxy steps.

4. Method according to one of the preceding claims, **characterized in that** the first insulating layer has a first insulating sublayer, which is applied to the semiconductor substrate, and a second insulating sublayer, which is applied to the first insulating sublayer.

5. Method according to one of the preceding claims, **characterized in that** the first insulating sublayer is silicon oxide.

6. Method according to one of the preceding claims, **characterized in that** the second insulating sublayer is silicon nitride.

7. Method according to one of the preceding claims, **characterized in that** the second insulating layer is silicon oxide.

8. Method according to one of the preceding claims, **characterized in that** the conductive layer is doped polysilicon.

9. Method according to one of the preceding claims, **characterized in that** the electrical resistance from the conductive layer to the active region of the base is reduced by means of a heat treatment step.

10. Method according to one of the preceding claims, **characterized in that** the emitter is produced by polysilicon deposition.

11. Method according to one of the preceding claims, **characterized in that** the emitter is produced by epitaxial deposition.

12. Method according to one of the preceding claims, **characterized in that** the base includes at least one layer of silicon-germanium.

13. Method according to one of the preceding claims, **characterized in that** the semiconductor substrate does not have an epitaxial layer.

## Revendications

1. Procédé de production d'un transistor bipolaire comprenant les stades suivants dans lesquels :
a) on se procure un substrat semi-conducteur ayant un domaine conducteur ;
b) on dépose au moins une première couche isolante, au moins une couche conductrice et au moins une deuxième couche isolante, les unes après les autres sur le substrat semi-conducteur ;
c) on dépose un masque ;
d) on effectue une attaque anisotrope de la deuxième couche isolante et de la couche conductrice ;
e) on effectue une oxydation thermique de la paroi latérale de la couche conductrice de manière à produire une couche d'oxyde sur la paroi latérale de la couche conductrice ;
f) on effectue une attaque anisotrope de la première couche isolante de manière à produire une ouverture vers le domaine conducteur ;
g) on produit un collecteur par épitaxie sélective dans l'ouverture ;
h) on attaque immédiatement ensuite la couche d'oxyde sur la paroi latérale de la couche conductrice ;
i) on produit une base qui est reliée à la couche conductrice par épitaxie sélective dans l'ouverture ; et
j) on produit un émetteur.

2. Procédé de production d'un transistor bipolaire comprenant les stades suivants dans lesquels :
a) on se procure un substrat semi-conducteur ayant un domaine conducteur ;
b) on dépose au moins une première couche isolante, au moins une couche conductrice et au moins une deuxième couche isolante, les unes après les autres sur le substrat semi-conducteur ;
c) on dépose un masque ;
d) on effectue une attaque anisotrope de la deuxième couche isolante et de la couche conductrice ;
e) on effectue une oxydation thermique de la paroi latérale de la couche conductrice de manière à produire une couche d'oxyde sur la paroi latérale de la couche conductrice ;
f) on effectue une attaque anisotrope de la première couche isolante de manière à produire une ouverture vers le domaine conducteur ;
g) on enlève par attaque la couche d'oxyde sur la paroi latérale de la couche conductrice ;
h) on produit immédiatement ensuite par épitaxie sélective dans l'ouverture un collecteur et une base qui est reliée à la couche conductrice ; et
i) on produit un émetteur.

3. Procédé suivant l'une des revendications précédentes, **caractérisé en ce que** l'on règle le dopage du collecteur et/ou de la base pendant les stades d'épitaxie.

4. Procédé suivant l'une des revendications précédentes, **caractérisé en ce que** la première couche isolante a une première sous-couche isolante qui est déposée sur le substrat semi-conducteur et une deuxième sous-couche isolante qui est déposée sur la première sous-couche isolante.

5. Procédé suivant l'une des revendications précédentes, **caractérisé en ce que** la première sous-couche isolante est de l'oxyde de silicium.

6. Procédé suivant l'une des revendications précédentes, **caractérisé en ce que** la deuxième sous-couche isolante est du nitrure de silicium.

7. Procédé suivant l'une des revendications précédentes, **caractérisé en ce que** la deuxième couche isolante est de l'oxyde de silicium.

8. Procédé suivant l'une des revendications précédentes, **caractérisé en ce que** la couche conductrice est du polysilicium dopé.

9. Procédé suivant l'une des revendications précédentes, **caractérisé en ce que** l'on réduit par un stade thermique la résistance électrique de la couche conductrice vers la zone active.

10. Procédé suivant l'une des revendications précédentes, **caractérisé en ce que** l'on produit l'émetteur par un dépôt de polysilicium.

11. Procédé suivant l'une des revendications précédentes, **caractérisé en ce que** l'on produit l'émetteur par un dépôt épitaxial.

12. Procédé suivant l'une des revendications précédentes, **caractérisé en ce que** la base a au moins une couche en silicium-germanium.

13. Procédé suivant l'une des revendications précédentes, **caractérisé en ce que** le substrat semi-conducteur n'a pas de couche épitaxiale.
